# EUROPÄISCHE PATENTANMELDUNG

(11) **EP 1 980 862 A2**
(43) Veröffentlichungstag der Anmeldung: **15.10.2008**
(21) Anmeldenummer: 07007283.0
(22) Anmeldetag: 07.04.2007
(51) Int. Cl.: G01R 22/10, H02J 13/00, G01R 11/185

(54) **Elektronischer Elektrizitätszähler**

(30) Priorität: 22.03.2007 DE 102007013729
(71) Anmelder: EMH Elektrizitätszähler GmbH & Co KG, 19243 Wittenburg (DE)
(72) Erfinder: Malek, Norbert, 21438 Thieshope (DE)
(74) Vertreter: Hauck Patent- und Rechtsanwälte

(57) **Zusammenfassung**

Elektronischer Elektrizitätszähler mit einem Mikroprozessor (14), einem Speicher, einer Echtzeituhr (18), einer Vorrichtung (12) zur Messung elektrischer Energie, einer Anzeige (20) und einer Schnittstelle (16) für das Auslesen von Energiedaten und sonstigen Daten, wobei der Elektrizitätszähler eine weitere Schnittstelle (26) aufweist, die über eine Übertragungsstrecke mit einem Temperatursensor (22) verbunden ist, der Prozessor Mittel aufweist zur Einspeicherung von Temperaturdaten im Speicher in vorgegebenen Zeitintervallen oder abhängig von im Prozessor registrierten Ereignissen und Verknüpfung mit den Energiedaten.

## Beschreibung

Die Erfindung bezieht sich auf einen elektronischen Elektrizitätszähler nach dem Patentanspruch 1.

Elektrizitätszähler werden bekanntlich zur Messung von verbrauchter oder erzeugter elektrischer Energie oder Leistung verwendet. Zunehmend setzen sich elektronische Meßgeräte durch. Sie weisen eine längere Standzeit auf und sind besser gegen Manipulationen gesichert. Mit zunehmender Komplexität der Meßaufgabe aber auch zur Manipulationserkennung werden Mikrorechner eingebaut. Eine umfangreiche Manipulationserkennung findet vorwiegend in einfachen Anwendungen, wie den Zählern für Tarifkunden, Anwendung. Eine hohe Komplexität der Meßaufgabe wird vornehmlich bei sogenannten Sondervertragsabnehmern gewünscht. Es ist auch zu beobachten, daß die Funktionalität der Meßgeräte steigt.

Es ist bekannt, Meßdaten der Zähler über Modems, die leitungsgebunden über analoge Telefonleitungen oder über drahtlose Telefonnetze oder das Internet kommunizieren, auszulesen. Im sogenannten Tarifkundenbereich setzen sich zunehmend drahtgebundene Kommunikationssysteme, die über Energieversorgungsleitungen kommunizieren (PLC) oder Kurzstreckenfunksysteme zur automatischen Ablesung der Zählerdaten durch.

Elektrizitätszähler für Sondervertragskundenanwendungen sind meist durchgängig mit internen Echtzeituhren ausgestattet, die für Tarifschaltzwecke verwendet werden oder zum zeitgesteuerten Speichern von Meßwerten. Diese Zähler sind üblicherweise mit Lastgangspeichern ausgestattet, die zum Beispiel regelmäßig alle 15 Minuten einen Leistungs- oder Energiewert im internen Gerätespeicher ablegen. Um über die Netzverhältnisse besser informiert zu sein, ist auch bekannt, neben Leistungs- und Energiewerten auch die Werte der Meßspannung zeitgesteuert im Speicher der Elektrizitätszähler abzulegen. Es ist allgemein bekannt, in Verbindung mit Betriebsmitteln für die Energieübertragung und -verteilung, wie z.B. Transformatoren, die Temperatur zu messen.

Der Erfindung liegt die Aufgabe zugrunde, einen elektronischen Elektrizitätszähler zu schaffen, mit dem es möglich ist, Temperaturen, beispielsweise der Umgebung, eines Verbrauchers oder dergleichen mit Energiewerten zu verknüpfen.

Diese Aufgabe wird durch die Merkmale des Patentanspruchs 1 gelöst.

Der erfindungsgemäße elektronische Elektrizitätszähler weist eine weitere Schnittstelle auf, die über eine Übertragungsstrecke mit einem Temperatursensor verbunden ist. Der Prozessor im Elektrizitätszähler weist Mittel auf zur Einspeicherung von Temperaturdaten in einen Speicher in vorgegebenen Zeitintervallen oder abhängig von im Prozessor registrierten Ereignissen. Die Temperaturdaten können über den Prozessor verknüpft werden, so daß den ausgelesenen Energiedaten Temperaturwerte zugeordnet sind.

Aus US 6 847 300 B2 ist bekannt geworden, im Elektrizitätszähler einen Temperatursensor anzuordnen. Übersteigt der Temperaturwert einen Schwellwert, wird ein Leistungsschalter geöffnet. Im bekannten Fall erfolgt weder eine Messung außerhalb des Elektrizitätszählers noch eine Verknüpfung von Energiedaten mit Temperaturwerten.

Eine Lösung nach der Erfindung ermöglicht es, die Energieerzeugung besser örtlichen Wetterverhältnissen anzupassen und Betriebsmittel, wie zum Beispiel Transformatoren, Umformanlagen usw. zu überwachen. Eine Zuordnung der Temperaturwerte zu Meßwerten für Energie und Leistung ermöglicht die Erfassung von Schwankungen in Abhängigkeit von gemessenen Temperaturen.

Eine Verbindung von Temperatur-, Energie- und Leistungswerten mit Hilfe von getrennten einzelnen Geräten würde aufwendig sein, weil unterschiedliche Gerätetechniken unterschiedliche Datenübertragungsprotokolle bedingen. Eine Übertragung in eine Zentrale ist jedoch notwendig, da dort die Daten zusammengeführt und verwertet werden müssen. Wird ein Temperatursensor über einen getrennten Kommunikationskanal mit einer Zentrale verbunden, erfordert es beim Geräteverwender zwei Modems und zwei Auslesesysteme im Parallelbetrieb. Erschwerend kommt hinzu, daß Temperaturinformationen nicht ohne großen Zusatzaufwand zeitsynchron mit den Energiewerten aufgezeichnet werden können.

Bei der Erfindung kann der Temperatursensor an einem beliebigen Ort angeordnet und mit dem Elektrizitätszähler über eine geeignete Übertragungsstrecke verbunden werden. Mit Hilfe der Erfindung können in Zeitintervallen gemessene Temperaturen mit Energie- und Leistungswerten verknüpft werden, um zum Beispiel Grenzwerte zu überwachen und das Überschreiten der Grenzwerte im Elektrizitätszähler, d.h. im Mikroprozessor zu protokollieren und Alarme auszulösen.

Nach einer Ausgestaltung der Erfindung enthalten die Temperaturdaten eine Zeitinformation. Mit einem "Zeitstempel" kann das zeitliche Auftreten der Temperaturinformation dokumentiert werden. Damit wird die Analyse von Energiewerten mit zugehörigen Temperaturinformationen deutlich vereinfacht.

Nach einer weiteren Ausgestaltung der Erfindung kann der Mikroprozessor ein Alarmsignal erzeugen, das an der ersten Schnittstelle oder an einer weiteren Schnittstelle oder einem Schnittstellenkontakt ansteht wenn zum Beispiel ein Maximalwert für die Temperatur überschritten wurde.

Die Übertragungsstrecke zwischen Temperatursensor und Elektrizitätszähler kann drahtbehaftet oder drahtlos sein. Besitzt der Temperatursensor einen analogen Ausgang, wird dieser vorzugsweise über eine Drahtverbindung mit der zweiten Schnittstelle verbunden. Selbstverständlich kann ein digitaler Ausgang des Temperatursensors ebenfalls über eine Drahtverbindung mit dem Zähler verbunden sein. Hier besteht jedoch die Alternative, die Übertragungsstrecke drahtlos zu machen und zum Beispiel eine Kurzfunkstrecke einzurichten. Bei Verwendung einer Leitung kann nach einer Ausgestaltung der Erfindung eine sogenannte Vierdrahtleitung vorgesehen sein mit einem Leitungspaar für die Meßsignale und einem für die Abfragesignale. Eine derartige Vierdrahtmeßtechnik ist jedoch allgemein bekannt.

Die Weiterverarbeitung der Temperaturmeßwerte im Mikrorechner erfolgt entsprechend der gestellten Meßaufgabe. Beispielsweise können Maximalwerte, Minimalwerte oder Mittelwerte gefordert sein, die innerhalb eines vorgegebenen Zeitintervalls aufzuzeichnen sind. Im Digitalverfahren werden die Temperaturinformationen vor der Übergabe an den Zähler in ein digitales Format umgewandelt. Dies kann zum Beispiel dadurch geschehen, daß Temperatursensor und Analogdigitalwandler eine Einheit sind. Die Temperaturinformationen müssen in diesem Fall in ein digitales Format umgewandelt werden. Hierfür können vorzugsweise temperaturproportionale Frequenzen/Impulsdauern oder Datenworte verwendet werden.

Beim analogen Verfahren ist der Temperatursensor im einfachsten Fall ein temperaturempfindlicher Widerstand, zum Beispiel PT1000. Er ist über eine Drahtverbindung mit dem Elektrizitätszähler verbunden. Dieser enthält einen Analogdigitalwandler, um die Temperaturdaten digitalisieren und im Speicher ablegen zu können. Das Abfragesignal ist vorzugsweise ein definierter Strom, der zum Beispiel mit einem Grenzwert verglichen wird. Bei Überschreitung erfolgt eine Registrierung in einem Register oder einem Logbuch.

Beim digitalen Verfahren kann der Temperatursensor auf digitalem Wege, zum Beispiel als temperaturabhängige Frequenz, Pulsweite oder digitales Datenwort die Information drahtbehaftet oder drahtlos auf den Zähler übermitteln. Bei drahtbehafteter Übermittlung kann ein zweiadriges oder abgeschirmtes Kabel verwendet werden. Die Beschaffenheit der Leitung hat auf das Meßergebnis keinen Einfluß.

In Anwendungen, bei denen die Verlegung von Verbindungsleitungen zwischen Sensor und Zähler unwirtschaftlich oder technisch unmöglich ist, kann die Übertragungsstrecke durch Kurzstreckenfunk realisiert sein. Hierfür können alle Arten von Funksystemen zur Anwendung kommen, zum Beispiel ZigBee, BlueTooth oder auch proprietäre Kurzstreckenfunksysteme, zum Beispiel im ISM-Bereich. Die Temperaturinformation kann mit einem vorhandenen oder zu schaffenden Übertragungsprotokoll zum Zähler übermittelt werden. In einfachen Anwendungen sendet der Temperatursensor periodisch seine Temperaturinformationen zum Elektrizitätszähler. Wenn der Elektrizitätszähler die Temperaturinformationen zeitgesteuert zu einem definierten Zeitpunkt benötigt, kann er eine Anforderung an den Temperatursensor senden, der seinerseits die Temperaturinformation an den Elektrizitätszähler sendet. In diesem Fall ist eine bidirektionale Funkverbindung erforderlich.

Die im Elektrizitätszähler gespeicherte Temperaturinformation läßt sich mit dem am Zähler angeschlossenen Auslesesystem einfach und ohne nennenswerte Zusatzkosten in die Zentrale des Zählerbetreibers übertragen.

Die Erfindung soll nachfolgend anhand eines einfachen Ausführungsbeispiels erläutert werden.

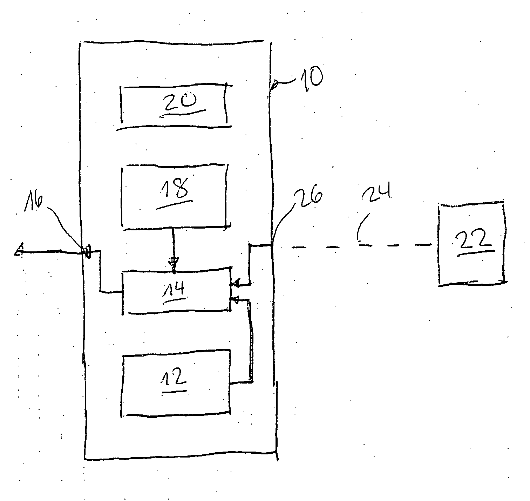

Die einzige Figur zeigt ein Blockschaltbild eines elektronischen Elektrizitätszählers nach der Erfindung.

In einem Gehäuse 10 eines Elektrizitätszählers befindet sich eine Vorrichtung 12 zur Messung von Energie bzw. Leistung, die von einem Erzeuger erzeugt oder von einem Verbraucher verbraucht wird. Die Meßwerte werden in einen Speicher eines Mikroprozessorsystems 14 eingespeichert. Sie können über eine erste Schnittstelle 16 auf eine bekannte Art und Weise ausgelesen werden, beispielsweise über ein Modem und von dort über eine drahtgebundene oder drahtlose Übertragungsstrecke zu einer nicht gezeigten Zentrale.

Der Elektrizitätszähler enthält außerdem eine Echtzeituhr 18 mit Taktgeber. Schließlich ist auch eine Anzeige 20 zur Anzeige der jeweils gemessenen Energiedaten vorgesehen.

Ein Temperatursensor 22 ist über eine Übertragungsstrecke 24 mit einer zweiten Schnittstelle 26 des Zählers verbunden. Die Schnittstelle ist ebenfalls mit dem Mikroprozessor 14 in Verbindung.

Der Temperatursensor kann ein analoges Temperatursignal über die Übertragungsstrecke 24, beispielsweise eine Zweidraht- oder Vierdrahtleitung, auf die Schnittstelle 26 übertragen und von dort auf den Mikroprozessor. Der Temperatursensor 22 kann auch einen Analogdigitalwandler enthalten. Die digitalen Daten können über die Übertragungsstrecke 24 auf drahtgebundenem oder drahtlosem Weg auf die Schnittstelle 26 übertragen werden, und zwar mittels eines geeigneten Übertragungsprotokolls. Im Falle analoger Temperatursignale enthält der Zähler einen Analogdigitalwandler, um die Temperaturmeßwerte in den Speicher des Prozessors 14 einspeichern zu können.

Gesteuert durch den Taktgeber der Echtzeituhr 18 werden die übertragenen Temperatursignale mit den Meßsignalen der Meßvorrichtung 12 verknüpft. Durch Abfrage über die Schnittstelle 16 können dann die Meßwerte mit den Temperaturwerten abgefragt werden, damit eine Aussage getroffen werden kann, bei welchen Temperaturwerten Meßwerte registriert wurden. Zu diesem Zweck kann der Temperatursensor 22 permanent seine Temperaturdaten auf den Prozessor 14 übertragen. Es ist jedoch auch möglich, dem Temperatursensor einen Zeitgeber zuzuordnen, der in vorgegebenen Zeitabständen Temperaturdaten auf den Elektrizitätszähler überträgt. Die Echtzeituhr 18 stellt dann fest, zu welchem Zeitpunkt die Temperatur gemessen wurde, um sie den zum gleichen Zeitpunkt gemessenen Energiewerten zuzuordnen. Schließlich kann eine Abfrage des Temperatursensors 22 vom Prozessor 14 aus erfolgen. In diesem Fall verläuft die Kommunikation bidirektional.

## Patentansprüche

1. Elektronischer Elektrizitätszähler mit einem Mikroprozessor, einem Speicher, einer Echtzeituhr, einer Vorrichtung zur Messung elektrischer Energie, einer Anzeige und einer Schnittstelle für das Auslesen von Energiedaten und sonstigen Daten, **dadurch gekennzeichnet, daß** der Elektrizitätszähler (10) eine weitere Schnittstelle (26) aufweist, die über eine Übertragungsstrecke (24) mit einem Temperatursensor (22) verbunden ist, der Prozessor (14) Mittel aufweist zur Einspeicherung von Temperaturdaten im Speicher in vorgegebenen Zeitintervallen oder abhängig von im Prozessor registrierten Ereignissen und Verknüpfung mit den Energiedaten.

2. Elektrizitätszähler nach Anspruch 1, **dadurch gekennzeichnet, daß** die Temperaturdaten mit einer Zeitinformation versehen sind.

3. Elektrizitätszähler nach Anspruch 1 oder 2, **dadurch gekennzeichnet, daß** der Prozessor ein Alarmsignal erzeugt, das an der ersten Schnittstelle (16) oder einer weiteren Schnittstelle oder einem Schnittstellenkontakt ansteht, wenn ein maximaler Temperaturwert überschritten wurde.

4. Elektrizitätszähler nach einem der Ansprüche 1 bis 3, **dadurch gekennzeichnet, daß** die Übertragungsstrecke (24) drahtlos ist.

5. Elektrizitätszähler nach einem der Ansprüche 1 bis 4, **dadurch gekennzeichnet, daß** der Temperatursensor (22) einen Analogdigitalwandler enthält und somit einen digitalen Ausgang aufweist.

6. Elektrizitätszähler nach einem der Ansprüche 1 bis 4, **dadurch gekennzeichnet, daß** ein Temperatursensor (22) mit analogem Ausgang vorgesehen ist, der über eine Drahtverbindung mit der zweiten Schnittstelle (26) verbunden ist.

7. Elektrizitätszähler nach Anspruch 5 oder 6, **dadurch gekennzeichnet, daß** eine Vierdrahtleitung vorgesehen ist mit für die Meßsignale und die Abfragesignale getrennten Leitungspaaren.

8. Elektrizitätszähler nach einem der Ansprüche 1 bis 3, **dadurch gekennzeichnet, daß** der Speicher für die Temperaturdaten auswechselbar eingebaut ist.

9. Elektrizitätszähler nach einem der Ansprüche 1 bis 8, **dadurch gekennzeichnet, daß** der Prozessor Maximalwerte, Minimalwerte oder Mittelwerte der Temperaturdaten in den Speicher einspeichert.

10. Elektrizitätszähler nach einem der Ansprüche 4 bis 9, **dadurch gekennzeichnet, daß** die Übertragungsstrecke (24) eine Kurzfunkstrecke ist.

11. Elektrizitätszähler nach einem der Ansprüche 1 bis 10, **dadurch gekennzeichnet, daß** der Temperatursensor (22) einen Taktgeber aufweist für die periodische Abgabe von Temperaturdaten an die zweite Schnittstelle (26).

12. Elektrizitätszähler nach einem der Ansprüche 1 bis 11, **dadurch gekennzeichnet, daß** der Prozessor (14) über die Übertragungsstrecke (24) ein Anforderungssignal an den Temperatursensor (22) sendet und der Temperatursensor (22) bei Empfang eines Anforderungssignals ein Temperatursignal an die zweite Schnittstelle (26) sendet.

13. Elektrizitätszähler nach einem der Ansprüche 1 bis 12, **dadurch gekennzeichnet, daß** der Temperatursensor (22) ein temperaturabhängiger Widerstand ist.
